# EUROPÄISCHE PATENTANMELDUNG

(11) **EP 2 073 030 A1**
(43) Veröffentlichungstag der Anmeldung: **24.06.2009**
(21) Anmeldenummer: 08105644.2
(22) Anmeldetag: 24.10.2008
(51) Int. Cl.: G01R 31/36, G01R 1/04, G01R 31/00

(54) **Sensoranordnung und Diagnoseverfahren für die Zustandserkennung einer Batterie in einem Kraftfahrzeug**

(30) Priorität: 19.12.2007 DE 102007061111
(71) Anmelder: Robert Bosch GmbH, 70442 Stuttgart (DE)
(72) Erfinder: Ben Salah, Amin, 74321, Bietigheim-Bissingen (DE)

(57) **Zusammenfassung**

Die Erfindung betrifft eine Sensoranordnung und ein Diagnoseverfahren für die Zustandserkennung einer Batterie (1) in einem Kraftfahrzeug, die zur Erfassung der elektrischen Zustandsgrößen der Batterie (1) in der Nähe der Polklemmen (2,3) der Batterie (1) angeordnet ist. Die Sensoranordnung (4) ist mit Sensoren für die elektrischen Zustandsgrößen Strom, Spannung und Temperatur im Bereich der Batterie (1), der Sensoranordnung (4) und/oder der Verbraucher ausgerüstet und ein Baustein (11) ist als Speichermittel zur Speicherung der Werte des Stroms, der Spannung und/oder der Temperatur als Werte für den Zustand (SOC) der Batterie (1) vorhanden, die im Verlauf eines Fertigungsprozesses des Kraftfahrzeugs auswertbar sind.

## Beschreibung

### Stand der Technik

Die Erfindung betrifft eine Sensoranordnung und ein Diagnoseverfahren für die Zustandserkennung einer Batterie, insbesondere als Bestandteil eines Energiemanagementsystems in Kraftfahrzeugen, nach der Gattung der Ansprüche 1 und 2.

Um den Batteriezustand in einem Kraftfahrzeug zu ermitteln, kommen in der Regel an sich bekannte Batteriesensoren oder auch entsprechende elektronische Schaltungen in Batteriemanagementsystemen zum Einsatz. Mit dem Einsatz eines solchen Batteriesensors kann man basierend auf gemessenen Strom-, Spannungs- oder Temperaturwerten den Zustand der Batterie ermitteln und überwachen. Hiermit können verschiedene Batteriemanagementsysteme angewendet werden können, um sogenannte Tiefentladungen der Batterie zu vermeiden und auch die Startfähigkeit des Fahrzeuges weiterhin sicherzustellen.

Es ist beispielsweise aus der DE 10 2005 039 587 A1 bekannt, dass eine Erfassung des Zustands einer Batterie im Bordnetz eines Kraftfahrzeuges mit einer Batteriesensoreinheit durchgeführt wird. Diese Batteriesensoreinheit als Messstrecke mit einem Shuntwiderstand wird direkt an eine Polklemme der Batterie angeklemmt und kombiniert praktisch die Messstrecke mit der mechanischen Anschlusseinheit.

Weiterhin ist in der DE 10 2006 013 911 A1 beschrieben, dass ein Kommunikationsweg zwischen der Erfassung der Messwerte zur Prüfung elektrischer Verbraucher im Kraftfahrzeug und der Bewertung dieser daraus gewonnenen Daten über einen CAN- oder LIN-Bussystem einer Rechnereinheit zur Verfügung gestellt wird.

Bei den bisher bekannten Anordnungen oder Verfahren wird der sogenannte SOC-Zustand der Batterie (SOC= State of Charge) auch während der Fertigung eines Fahrzeugs überprüft und basierend auf dieser Information können defekte oder entladene Batterien entdeckt werden. Während der Fertigung können jedoch die Batterien abgeklemmt werden; dabei wird nach jedem neuen Ab- und Anklemmen der Batterie der angeschlossene Batteriesensor neu initialisiert, sodass die SOC Information in diesen Fällen nicht mehr zuverlässig ist und nicht mehr zur Bestimmung des Batteriezustandes verwendet werden kann, auch wenn die Batterie nicht ausgetauscht worden ist.

### Offenbarung der Erfindung

Die Erfindung geht von einer Sensoranordnung für die Zustandserkennung einer Batterie in einem Kraftfahrzeug aus, die zur Erfassung der elektrischen Zustandsgrößen der Batterie in der Nähe der Polklemmen der Batterie angeordnet ist. Um die oben beschriebenen Probleme während der Fertigung des Fahrzeugs zu vermeiden, soll gemäß der Erfindung die Berechnung der SOC-Werte so angepasst werden, um weiterhin auch nach einem Batterie Ab- und Anklemmen eine zuverlässige Verwendung dieser Information für die Ermittlung des Batteriezustandes auf einfache Weise zu ermöglichen.

Erfindungsgemäß ist ein Baustein als Speichermittel zur Speicherung des Verlaufs der Werte des Stroms, der Spannung und der Temperatur als Werte für den Zustand (SOC) der Batterie vorhanden, mit dem die Zustandswerte im Verlauf eines Fertigungsprozesses des Kraftfahrzeugs auswertbar sind. In vorteilhafter Weise werden während des Fertigungsprozesses des Fahrzeugs die Werte für den Zustand (SOC) der Batterie des Kraftfahrzeugs periodisch oder auf Anforderung gespeichert, sodass nach einem Abklemmen und einem neuen Anklemmen derselben Batterie die Werte für den Zustand (SOC) der Batterie aus dem Baustein ausgelesen werden können. In dem Baustein kann vorzugsweise auch eine Information über eine eindeutige Codierung der Batterie (1) ausgewertet werden.

Durch die erfindungsgemäße Verbesserung der SOC-Berechnung kann diese somit zuverlässig während der Fahrzeugfertigung verwendet werden, sodass überflüssige Ladungen oder Fehldiagnosen der Batterien vermieden werden können. Die Sensoranordnung als Batteriesensor kann während der Fahrzeugfertigung eine zuverlässige Information über den Zustand (SOC) der Batterie geben, sodass auch defekte oder schlecht geladene Batterien während der Fertigung entdeckt werden können.

### Kurze Beschreibung der Zeichnung

Die Erfindung wird nachfolgend anhand des in den Figuren der Zeichnung gezeigten Ausführungsbeispiels erläutert. Dabei zeigen:
Figur 1 ein schematisches Blockschaltbild einer Anordnung einer Sensoranordnung im Bereich der Batterie eines Kraftfahrzeuges und einer Auswerteeinrichtung und
Figur 2 ein Ablaufdiagramm eines Diagnoseverfahrens für eine Batterie eines Fahrzeugs während des Fertigungsprozesses.

### Ausführungsformen der Erfindung

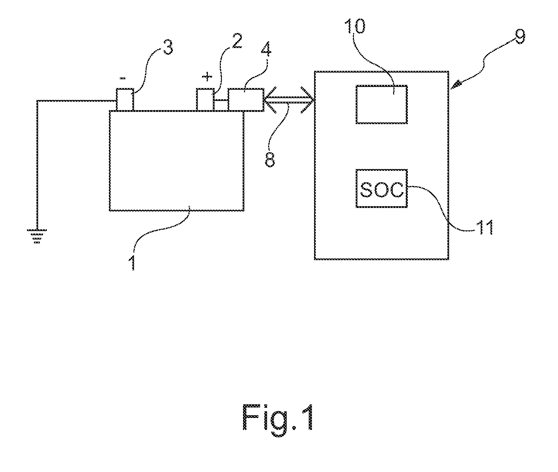

In Figur 1 ist eine Batterie 1 für ein Kraftfahrzeug gezeigt, deren Zustand durch Messung elektrischer Größen, insbesondere Strom, Spannung oder Temperatur, möglichst nahe an den Polklemmen 2 (+) und 3 (-) der Batterie 1 mit einer Sensoranordnung 4 als Batteriesensor erfasst werden soll.

Über einen hier schematisch gezeigten LIN-Bus 8 können die Signale der Sensoranordnung 4 zu einer hier nicht näher erläuterten Auswerteeinheit 9 geführt werden, die zusätzlich zur Auswertung der Signale auch eine Durchführung von einigen Tests generieren kann. Unter anderem kann in der Auswerteeinheit 9 in einem Baustein 10 ein Code zur eindeutigen Identifizierung der Batterie ausgewertet werden und in einem Baustein 11 kann der mittels der Sensoranordnung 4 erfasste Zustand (SOC) der Batterie gespeichert werden.

Vor einer ersten Montage der Batterie 1 im Fahrzeug war die Batterie 1 durch die Lagerung für eine lange Phase in Ruhe, sodass die Ruhespannung der Batterie 1aus der von der Sensoranordnung 4 gemessenen ersten Spannung ermittelt werden kann. Basierend auf dieser Spannung, kann dann die Sensoranordnung 4 eine zuverlässige Bestimmung des Zustandes als sogenanntes Quick SOC durchführen. Nach dem Quick SOC, wird dann der Zustand SOC in der Sensoranordnung 4 in aktiven Phasen und während der Fertigung dauerhaft aktualisiert. Abhängig vom Fertigungsprozess können dabei unterschiedliche Verfahren durchgeführt werden. Im Fertigungsprozess kann dann die Speicherung der SOC-Werte getriggert werden und anschließend kann die Batterie 1 abgeklemmt werden. Nach dem Wiederanklemmen der Batterie 1 kann die Sensoranordnung auf die gespeicherten SOC-Werte zurückgreifen.

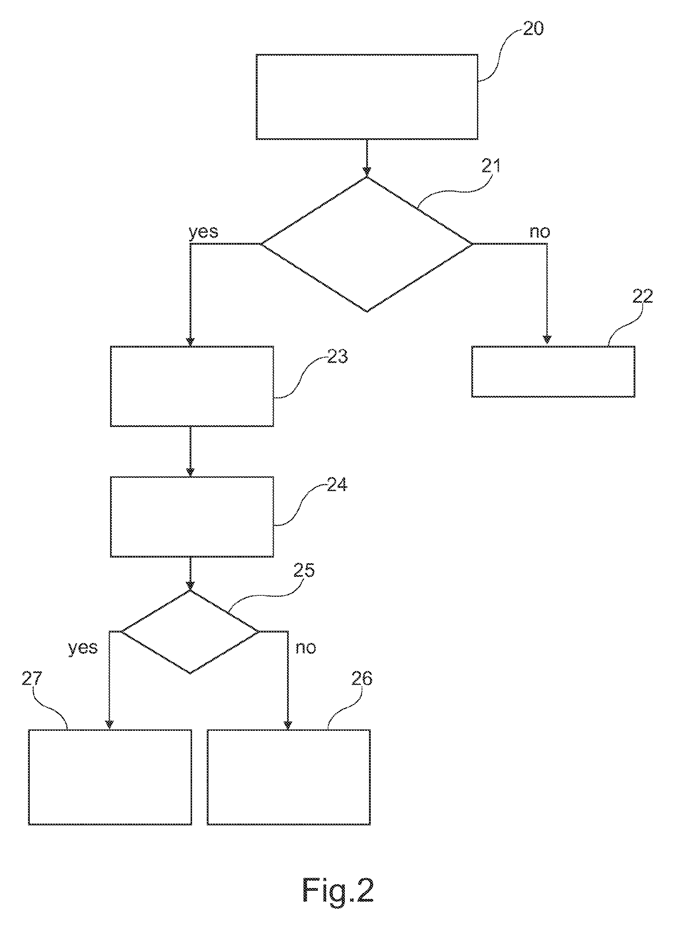

In Figur 2 ist im Ablauf eines Diagnoseverfahrens dargestellt, dass nach einer ersten Montage der Batterie 1 (Block 20) für den Fall eines Abklemmens der Batterie 1 im Fertigungsprozess geprüft wird (Block 21) ob weitere Resets notwendig sind; falls nein kann die Berechnung fortgesetzt werden und die der Zustand (SOC) kann getriggert werden (Block 22), falls ja wird der Zustand (SOC) des aktuellen Diagnoseverfahren im Baustein 11 vorzugsweise periodisch gespeichert (Block 23,24). Es wird hier erwartet, dass nach einem Tausch der Batterie 1 eine neue Codierung der Batterie 1 stattfindet oder ein sogenanntes Tausch-Flag an die Sensoranordnung 4 gesendet wird (Block 25). Falls nicht, kann die Sensoranordnung 4 eine unzuverlässige SOC-Berechnung zurückmelden (Block 26). Zusätzlich wird ein Timer eingeführt um einen möglichen Misuse im Feld bei einem Tausch der Batterie 1 vorzubeugend, anderenfalls kann mit den gespeicherten SOC-Werten weitergearbeitet werden (Block 27).

Die zuvor beschriebene Lösung hat den Vorteil, dass die Speicherung im Baustein 11 nur zu vorgegebenen Zeitpunkten gemacht werden muss; allerdings bleibt diese Lösung vom Fertigungsprozess abhängig, wobei hier beim Abklemmen der Batterie 1 während des Fertigungsprozesses mit einem Risiko hinsichtlich der Zuverlässigkeit der Daten über den Zustand (SOC) der Batterie 1 verbunden ist. Eine weitere Lösung, die vom Fertigungsprozess unabhängig ist, kann darin bestehen, dass die Batterie 1 eine eindeutige Codierung aufweist.

Der zuvor beschriebene Ablauf ist der gleiche, wenn die Lade- und/oder Entladebilanz der Batterie im Baustein 11 gespeichert wird. Es wird hier dann lediglich die Menge der Ladung, die in oder aus der Batterie 1 geflossen ist, während der Fertigung gespeichert.

## Patentansprüche

1. Sensoranordnung für die Zustandserkennung einer Batterie (1) in einem Kraftfahrzeug, die zur Erfassung der elektrischen Zustandsgrößen der Batterie (1) in der Nähe der Polklemmen (2,3) der Batterie (1) angeordnet ist, **dadurch gekennzeichnet, dass** die Sensoranordnung (4) mit Sensoren für die elektrischen Zustandsgrößen Strom, Spannung und Temperatur im Bereich der Batterie (1), der Sensoranordnung (4) und/oder der Verbraucher ausgerüstet ist und das ein Baustein (11) als Speichermittel zur Speicherung der Werte des Stroms, der Spannung und/oder der Temperatur als Werte für den Zustand (SOC) der Batterie (1) vorhanden ist, die im Verlauf eines Fertigungsprozesses des Kraftfahrzeugs auswertbar sind.

2. Sensoranordnung für die Zustandserkennung einer Batterie (1) in einem Kraftfahrzeug, die zur Erfassung der elektrischen Zustandsgrößen der Batterie (1) in der Nähe der Polklemmen (2,3) der Batterie (1) angeordnet ist, **dadurch gekennzeichnet, dass** die Sensoranordnung (4) mit Sensoren für die elektrischen Zustandsgrößen Strom, Spannung und Temperatur im Bereich der Batterie (1), der Sensoranordnung (4) und/oder der Verbraucher ausgerüstet ist und das ein Baustein (11) als Speichermittel zur Speicherung der Werte des Stroms, der Spannung und/oder der Temperatur als Werte für die Lade- und/oder Entladebilanz der Batterie (1) vorhanden ist, die im Verlauf eines Fertigungsprozesses des Kraftfahrzeugs auswertbar sind.

3. Verfahren zur Zustandserkennung einer Batterie (1) und/oder eines Verbrauchers in einem Kraftfahrzeug nach Anspruch 1, **dadurch gekennzeichnet, dass** während des Fertigungsprozesses des Fahrzeugs die Werte für den Zustand (SOC) der Batterie (1) des Kraftfahrzeugs periodisch oder auf Anforderung gespeichert werden und das nach einem Abklemmen und einem neuen Anklemmen derselben Batterie (1) die Werte für den Zustand (SOC) oder der Lade- und/oder Entladebilanz der Batterie (1) aus dem Baustein (11) ausgelesen werden.

4. Verfahren zur Zustandserkennung einer Batterie (1) nach Anspruch 3, **dadurch gekennzeichnet, dass** in einem Baustein (10) eine Information über eine eindeutige Codierung der Batterie (1) ausgewertet wird.
